# EUROPÄISCHE PATENTSCHRIFT

(11) **EP 1 216 483 B1**
(45) Veröffentlichungstag und Bekanntmachung des Hinweises auf die Patenterteilung: **13.01.2010**
(21) Anmeldenummer: 00965762.8
(22) Anmeldetag: 16.08.2000
(51) Int. Cl.: H01J 37/30, H01J 37/317

(54) **ELEKTRONENOPTISCHE LINSENANORDNUNG MIT VERSCHIEBBARER ACHSE**
ELECTRON-OPTICAL LENS ARRANGEMENT WITH A DISPLACEABLE AXIS
ENSEMBLE LENTILLE OPTOELECTRONIQUE A AXE DECALABLE

(30) Priorität: 18.09.1999 DE 19944857
(43) Veröffentlichungstag der Anmeldung: 26.06.2002
(73) Patentinhaber: Ceos Corrected Electron Optical Systems GmbH, 69126 Heidelberg (DE)
(72) Erfinder: ROSE, Harald, 64289 Darmstadt (DE); SCHMID, Peter, 64289 Darmstadt (DE); JANZEN, Roland, 64289 Darmstadt (DE)
(74) Vertreter: Pöhner, Wilfried Anton, Dr.
(86) Internationale Anmeldenummer: PCT/DE2000/002797
(87) Internationale Veröffentlichungsnummer: WO 2001/022469

(56) Entgegenhaltungen:
- EP-A- 0 660 370
- DE-A- 19 634 456
- US-A- 5 793 048

## Beschreibung

Die Erfindung bezieht sich auf eine elektronenoptische Linsenanordnung mit verschiebbarer Achse, gemäss Oberbegriff des Anspruches 1.

Eine der Hauptanwendungsgebiete der Elektronenstrahllithographie ist die Herstellung elektronischer Bauelemente und integrierter Schaltungen auf der Oberfläche scheibenförmiger Halbleiterkristalle (Wafer). Deren angestrebte Verkleinerung erfordert das Schreiben von Strukturen möglichst minimaler Größe. Der entscheidende Vorteil gegenüber der optischen Lithographie besteht darin, daß die Wellenlängen der Elektronen im Vergleich zum Licht wesentlich geringer sind und somit die Abbildungkleinerer Strukturen erlaubt. Desweiteren besitzen Elektronenstrahlschreiber die Fähigkeit sehr kleine Strukturen schnell zu schreiben, haben jedoch gegenüber lichtoptischen Projektionen den Nachteil der längeren Belichtungszeit, das Erfordernis der Herstellung eines guten Vakuums und eines in der Bildebene schnell und präzise bewegbaren Tisches, wobei sich diese Forderung daraus ergibt, daß die bekannten elektronenoptischen Ablenkelemente den Strahl nur im Milimeterbereich fehlerarm auszulenken vermögen. Aus diesem Grunde wird die Elektronenstrahllithographie bislang vor allem für die Herstellung von Masken zur optischen Lithographie und für die Herstellung von Custom Chips verwendet, bei denen die benötigte Zeit von untergeordneter Bedeutung ist.

Von Goto und Soma, veröffentlicht in der Zeitschrift "Optik" 48, 255 - 270 MOL (moving objective lense), 1977, wird der Vorschlag gemacht, einem Rundlinsenfeld Ablenkfelder zu überlagern durch die sich das Bildfeld erweitern läßt, was noch nicht ausreicht um ein Bildfeld von der Ausdehnung eines Wafers zu erhalten, so daß nach wie vor der Bohrungsdurchmesser der Rundlinse das nutzbare Bildfeld in entscheidender Weise begrenzt. Zudem ist weiterhin eine in einer Ebene senkrecht zum Elektronenstrahl zweidimensiomal bewegliche Werkstückhalterung erforderlich, von der die Leistungsfähigkeit des Systems und die minimale Größe der erzeugbaren Strukturen von der Bewegungsgenauigkeit abhängt und die Bewegungsgeschwindigkeit der Halterung die maximale Schreibgeschwindigkeit bestimmt.

Zur Fokussierung geladener Teilchen sind Zylinderlinsen bekannt (H. Rose, Optik 36, 1971, Seite 19 - 36), bei denen die Elektroden bzw. Polschuhe zur Erzeugung des elektrischen bzw. magnetischen Feldes eine spaltförmige Öffnung aufweisen, deren Längsaches senkrecht zur optischen Achse ausgerichtet ist, wobei diese mit der optischen Achse eine Ebene aufspannt, die die Mittelebene der Zylinderlinsenanordnung beschreibt. Eine stigmatische Abbildung ist mit Hilfe von Zylinderlinsen prinzipiell unmöglich, da lediglich senkrecht zur Spaltrichtung eine fokussierende Wirkung eintritt, wohingegen die Bewegungskomponenten der abzubildenden geladenen Teilchen parallel des Spaltes keine Ablenkung erfahren (oder umgekehrt). Die erhaltenen stabförmigen astigmatischen Punktbilder sind zur Abbildung ungeeignet. Aus der WO9809313 ist eine elektronenoptische Linsenanordnung bekannt, bei welcher die Zylinderlinse eine Quadrupolfeld überlagert und derart zugeordnet wird, daß die fokussierende Ebene des Quadrupoles in Richtung des Spaltes der Zylinderlinse ausgerichtet ist und demzufolge die defokussierende Ebene senkrecht dazu bei koaxialen optischen Achsen verläuft. Demnach erfolgt die Fokussierung in der einen, der Spaltebenen durch das Quadrupolfeld und in der senkrecht hierzu verlaufenden Ebene durch die Zylinderlinse, deren Stärke so einzustellen ist, daß eine Eliminierung des defokussierenden Anteiles des Quadrupolfeldes eintritt. Wird die fokussierende Wirkung in beiden senkrecht zueinander verlaufenden Ebenen gleich einjustiert ergeben die Kombination der beiden Linsen stigmatische Abbildungen.

Hiervon ausgehend hat sich die Erfindung die Schaffung einer elektronenoptischen Linsenanordnung zur Aufgabe gemacht, welche in einer Richtung einen sehr großen Arbeitsbereich aufweist und den Strahl auch in den weit von der Mitte entfernten Bereichen im wesentlichen stets senkrecht auf das Objekt auftreffen läßt.

Gelöst wird diese Aufgabe erfindungsgemäß durch,
die im Kennzeichen des Anspruchs 1 angegebenen Merkmale.

Der Kerngedanke der Erfindung besteht darin, der aus Zylinderlinse und Quadrupolfeld bestehenden elektronenoptischen Linsenanordnung ein Ablenksystem vorzuschalten, welches den in aller Regel aus Elektronen bestehenden Teilchenstrahl im wesentlichen achsparallel und in Richtung des Spaltes der Zylinderlinse verschiebt und das Quadrupolfeld im Auftreffpunkt des Teilchenstrahles innerhalb der Linsenanordnung erzeugt wird. Die räumliche Verschiebung des Quadrupolfeldes erfolgt auf elektronischem Wege, d. h. das Quadrupolfeld wird im Bereich des Auftreffpunktes des Teilchenstrahles durch Beaufschlagung der dort befindlichen Elektroden (bei elektrischen Linsen) oder Polschuhen (bei magnetischen Linsen) erregt. Für die konkrete bauliche Realisierung sind grundsätzlich zwei Prinzipien denkbar: Zum einen läßt sich das Quadrupolfeld diskontinuierlich in Richtung des Spaltes der Zylinderlinse sprunghaft verschieben, so daß bei stetigem Verschieben des Teilchenstrahles dieser in der Regel etwa außerhalb der Achse des Quadrupolfeldes durch die Linsenanordnung tritt. Diese geringen Abweichungen von der Achse des Quadrupolfeldes geben Anlaß zum Entstehen elektronenoptischer Bildfehler, die aufgrund der geringen Abweichungen jedoch so klein sind, daß sie die Qualität der optischen Abbildung nicht nennenswert zu beeinträchtigen vermögen. Daneben sind auch Anordnungen denkbar, bei denen synchron zur Ablenkung des Teilchenstrahles und somit kontinuierlich das Quadrupolfeld in Richtung des Spaltes der Zylinderlinse verschoben wird. Eine entsprechende Justierung läßt erreichen, daß der Teilchenstrahl exakt in der Achse des Quadrupolfeldes verläuft, so daß ein Auftreten von aufgrund des außeraxialen Durchtritts des Teilchenstrahles durch Quadrupolfeld erzeugte Bildfelder unterbleiben. Aufgrund der Tatsache, daß die Erzeugung des Quadrupolfeldes die baulich konstruktive Anordnung von Elektroden bzw. Polschuhen vorsehen, die einen Eigenplatzbedarf erfordern und demzufolge in Richtung des Spaltes der Zylinderlinse von endlicher Ausdehnung sind, erweist sich die Verschiebung des Quadrupolfeldes in infinitesimal kleinen Schritten als theoretisch erwünscht, in der Praxis jedoch nur als approximierbar. Der Teilchenstrahl wird bei der vorgeschlagenen Anordnung auch in den von der Objektmitte weit entfernten Bereichen im wesentlichen senkrecht und in unveränderter optischer Abbildungsqualität auf das Objekt auftreffen. Ohne Qualitätseinbuße ist somit eine Verschiebung des Teilchenstromes über einen Bereich möglich, wie er durch die Breite des Spaltes der Zylinderlinse begrenzt wird. Das Ergebnis ist, daß sich eine exakte optische Abbildung entlang einer in Richtung des Spaltes der Zylinderlinse verlaufenden Geraden vornehmen läßt. Die durch die Bohrung der Rundlinsen bedingte Einschränkung des Bildfeldes entfällt.

Gegenüber den bisherigen Anordnungen der Elektronenlithographie zum Beschreiben des Objektes, bei denen eine zweidimensionale Verschiebung senkrecht zum Elektronenstrahl auf mechanischem Wege unabdingbar war, was bekanntlich eine erhebliche Einschränkung der Leistungsfähigkeit zur Folge hat, ist das Objekt nurmehr noch in einer Richtung senkrecht zum Spalt der Zylinderlinse, jedoch weiterhin in einer senkrecht zur optischen Achse verlaufenden Ebene und demzufolge nur noch eindimensional zu verschieben. Eine eindimensionale Verschiebung zudem bei geringerer Geschwindigkeit läßt ein wesentlich präziseres Arbeiten zu.

Die Benutzung geschieht im wesentlichen in an sich bekannter Weise indem das Objekt, bei dem es sich im Falle einer Elektronenlithographie häufig um einen Halbleiterwafer handeln wird, eindimensional senkrecht zur optischen Achse und auch zum Spalt der Zylinderlinse mechanisch verschiebbar fixiert wird. Senkrecht hierzu erfolgt das Beschreiben durch den Teilchenstrahl mit Hilfe der vorbeschriebenen elektronenoptischen Linsenanordnung in einem sehr langen linienförmigen Bereich, der in Richtung des Spaltes der Zylinderlinse verläuft und entlang dem eine gute stigmatische Abbildung aller Punkte möglich wird. Mit der vorbeschriebenen Anordnung kann bei einer Auflösung von 0,025 Mikrometer und einem Achsabstand von 5 mm eine verzeichnungsfreie Abbildung erfolgen. Im Ergebnis erhält man eine deutliche Vergrößerung des in Richtung des Spaltes der Zylinderlinse verlaufenden linienförmig abgebildeten Bereiches hoher optischer Qualität. Senkrecht hierzu, d. h. in Verschieberichtung des Objektes wird die Abbildungsqualität durch die Verschiebegenauigkeit der Mechanik weiterhin bestimmt, wobei darauf hinzuweisen bleibt, daß die Eindimensionalität und das langsamere Verschieben ein wesentlich präziseres Arbeiten der Mechanik zuläßt.

Im Rahmen der Erfindung steht grundsätzlich frei, ob Quadrupol- und/oder Zylinderfeld elektronisch oder magnetisch erzeugt werden. Als zweckmäßig wurde erkannt, daß Zylinder- und/oder insbesondere das zu verschiebende Quadrupolfeld elektrisch zu wählen, weil dann unter Umgehung von Remanenzen und Wirbelströmen eine schnelle Feldverschiebung möglich ist.

Zur konkreten Realisierung des in Richtung des Spaltes der Zylinderlinse verschiebbaren elektrischen Quadrupolfeldes wird die Mittelelektrode der Zylinderlinse in Richtung des Spaltes in einzelne elektrisch gegeneinander isolierte Einzelelektroden unterteilt, die individuell ansteuerbar sind. Zur Verschiebung und zur Erzeugung des gewünschten elektrischen Feldes werden sukzessive die Einzelelektroden unter entsprechende Spannung gesetzt. Das sukzessive Ansteuern der benachbarten Elektroden bewirkt die gewünschte Verschiebung.

Zur Reduzierung vieler, aufgrund der krummen optischen Achse hervorgerufenen Bildfehler zweiter Ordnung ist bevorzugt, die Felder und daraus resultierend die Funtamentalbahnen symmetrisch zur Mittelebene der Linse zu wählen.

Bislang beschrieben wurde eine Anordnung, bei der eine einzige Quelle (Elektronenquelle) den Teilchenstrahl zur Beschreibung des Objektes erzeugt und in der vorbeschriebenen Weise ablenkt. Eine wesentliche Verbreiterung des Bildfeldes in Richtung der fehlerfrei abbildenden, in Richtung des Spaltes der Zylinderlinse verlaufenden Gerade läßt sich dadurch erreichen, daß mehrere der vorbeschriebenen Anordnungen parallel zueinander und in Richtung des Spaltes der Zylinderlinse nebeneinander angeordnet werden, in der Weise, daß sich der Abbildungsbereich benachbarter Anordnungen überlappt oder doch zumindest aneinander anschließt. Bei N gleichartigen Anordnungen läßt sich dann eine N-fache Bildbreite erzielen. Aufgrund der Möglichkeit des synchronen Arbeitens jeder einzelnen Anordnung verbleibt es bei der Schreibdauer, die eine Einzelanordnung benötigt.

Eine weitere Möglichkeit der Verkürzung der Schreibdauer läßt sich dadurch erreichen, daß mehrere der vorbeschriebenen Anordnungen senkrecht zur Richtung des Spaltes und damit übereinander angeordnet sind. Hierdurch erreicht man, daß das Objekt gleichzeitig in mehreren, in Bewegungsrichtung des Objektes hintereinander liegenden Bereichen beschrieben wird, sodaß ein Teilchenstrahl nur einen einzigen Teilbereich abzudecken hat. Die Verschiebung des Objektes hat nur so zu erfolgen, daß der Strahl nur den ihm zugeordneten Bereich abdecken muß.

Die in der Spaltebene der Zylinderlinse wirkenden und diesen vorgeschalteten Ablenksysteme sollen ein möglichst senkrechtes Auftreffen auf das Objekt sicherstellen, d.h. der Teilchenstrahl ist achsparallel zu versetzen. Aus diesem Grunde empfiehlt sich das Ablenksystem aus zwei in Richtung des Teilchenstrahles hintereinander angeordneten Elementen aufzubauen, die in zwei gegensätzliche Richtungen ablenken, d.h. der Strahl wird im ersten Element von der optischen Achse weg ausgelenkt und im zweiten Element achsparallel ausgerichtet. Hierbei ist die räumliche Anordnung der Elemente zueinander und zur Zylinderlinse grundsätzlich beliebig. Eine einfache bauliche Realisierung könnte darin bestehen, im Eingangsbereich der Zylinderlinse das zweite Element durch Anbringung eines Dipoles anzuordnen. Wichtig ist, bei unterschiedlichen Ablenkungen die Paraxialität des Strahles zu gewährleisten. Im allgemeinsten Fall ist die Frage der Umsetzung der Ablenkung, sei es durch elektrische oder magnetische Felder, grundsätzlich beliebig.

Im Hinblick auf das der Linsenanordnung vorgeschalteten Ablenksystems wird eine Realisierung als bevorzugt angesehen, in der neben einem statischen magnetischen ein zweites in Richtung des Strahlenganges vorgeschaltetes zeitlich verändertes Magnetfeld vorgesehen wird. Durch unterschiedliche Beaufschlagung des letzteren wird der Teilchenstrahl achsparallel in Richtung des Spaltes der Zylinderlinse verschoben.

Von Vorteil ist, die Formung des Polschuhs des statischen Magnetfeldes so zu wählen, daß unabhängig von der Ablenkung des austretenden Teilchenstromes durch das vorgeschaltete Magnetfeld stets Paraxialität zum einfallenden Teilchenstrom erzeugt wird.

Weitere Einzelheiten, Vorteile und Merkmale der Erfindung lassen sich dem nachfolgenden Beschreibungsteil entnehmen, in dem anhand der Zeichnung ein Ausführungsbeispiel der Erfindung näher erläutert ist. Es zeigen:
- **Figur 1:**: ein in schematischer Darstellung gehaltenes Blockschaltbild der erfindungsgemäßen Linsenanordnung
- **Figur 2:**: N Anordnungen in Richtung des Spaltes der Zylinderlinse nebeneinander.

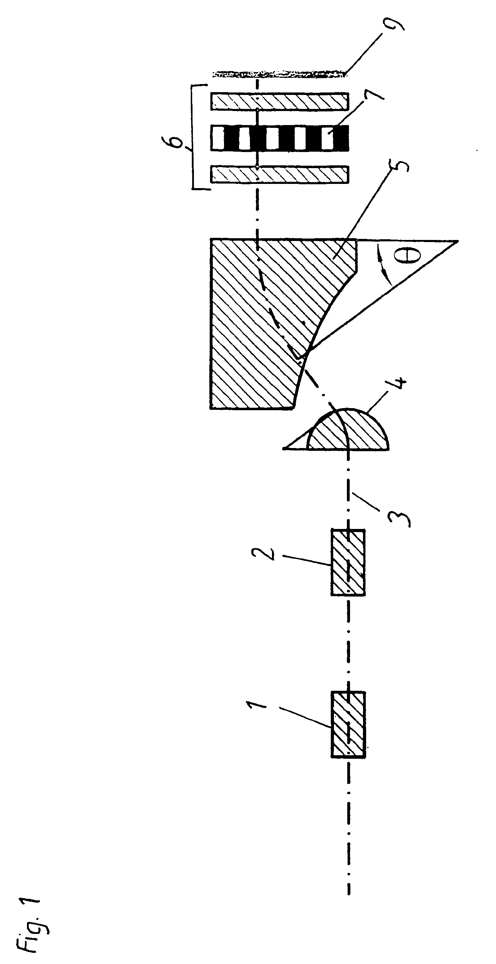

Die in Figur 1 widergegebene Linsenanordnung läßt sich in ihrem grundsätzlichen Aufbau in drei Bereichen unterteilen:

Der Teilchenstrom geht aus von Elementen, die die geladenen Teilchen, z. B. die Elektronen, erzeugen - dies geschieht im Element 1 - und anschließend zur Erzeugung eines Strahles fokussieren (Element 2). Dabei ist die einen gekrümmten Verlauf zeigende optische Achse (3) in strich-punktierter Linienführung widergegeben.

Nach dem Bereich der Teilchenerzeugung schließt sich der der Ablenkung an, welcher in Richtung des Strahlenganges aus einem ersten Magnetfeld (4) und einem sich daran anschließenden zweiten Magnetfeld (5) zusammensetzt, wobei im ersten Feld (4) durch Veränderung der Magnetfeldstärke eine unterschiedliche Abblenkung erzeugt wird und durch das weitere, jedoch statische Magnetfeld (5) eine im wesentlichen paraxiale Ausrichtung des Teilchenstromes erfolgt. Im Ergebnis erhält man aufgrund des Ablenksystemes (4, 5) einen in seinem Abstand zur Mittelachse einstellbaren paraxialen Versatz.

Die eigentliche Abbildung erfolgt im letzten Bereich, der aus einer Zylinderlinse (6) mit einer als Kammlinse ausgebildeten Mittelelektrode (7) aufgebaut ist. Durch sukzessives Beaufschlagen der einzelnen Elektroden mit einer Spannung geeigneten Größe läßt sich an unterschiedlichen Stellen ein Quadrupolfeld erzeugen. Die Ansteuerung hat derart zu erfolgen, daß im Auftreffpunkt des Teilchenstrahles ein Quadrupolfeld erregt wird mit einer solchen Stärke, daß eine Fokussierung des in Richtung des Spaltes verlaufenden Ebene auf den Bildpunkt eintritt und in der senkrecht hierzu verlaufenden Ebene aufgrund der Überlagerung des Feldes von Zylinderlinse und Quadrupol und geeigneter Einstellung des Zylinderfeldes ebenfalls eine Fokussierung auf demselben Bildpunkt stattfindet, so daß eine stigmatische Abbildung vorliegt. Durch sukzessives Ablenken des Teilchenstromes und entsprechendes Verschieben des Quadrupolfeldes wird in einer sich über die gesamte Breite des Spaltes erstreckenden Gerade eine stigmatische Abbildung möglich. Um das flächenhafte Beschreiben des mit "Wafer" bezeichneten Objektes (9) zu erhalten, muß dieser in einer senkrecht zur optischen Achse verlaufenden Ebene und zwar senkrecht zur Richtung des Spaltes verschoben werden. Im Vergleich zum Stand der Technik ist nunmehr eine eindimensionale und relativ langsame Verschiebung des Objektes vonnöten.

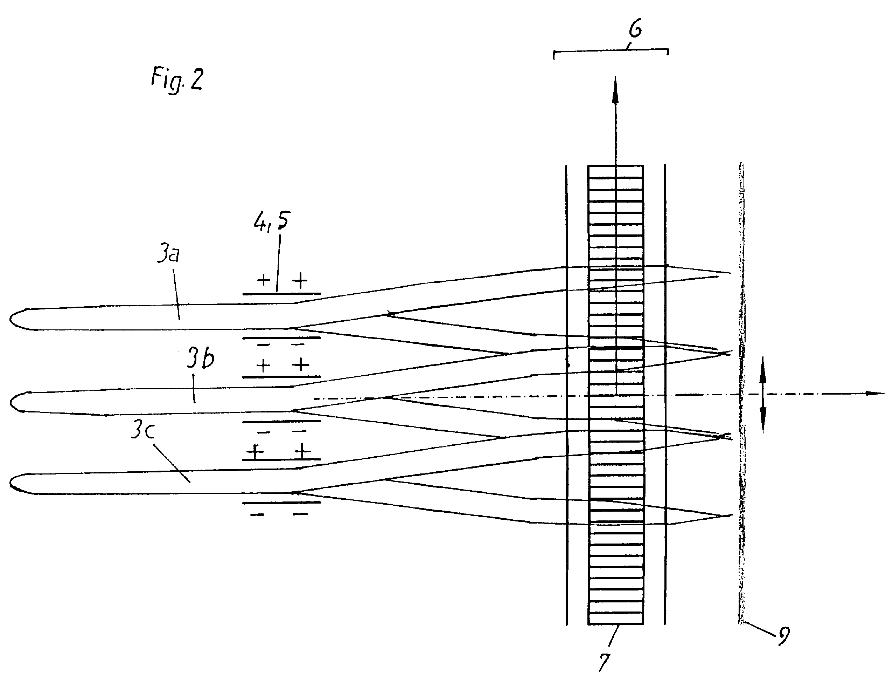

Figur 2 zeigt eine Linsenanordnung mit drei parallel zueinander angeordneten Vorrichtungen vorbeschriebener Art. Eingezeichnet sind drei Bündel (3a, 3b, 3c), die durch ein als Kondensator charakterisiertes Ablenksystem (4, 5) in Richtung des Spaltes der Zylinderlinse (6) verschoben wird. Dabei schließen sich die Felder aneinander an. Die Zylinderlinse (6) besteht aus einer kammartigen Mittelelektrode (7), die sukzessive und individuell zur Erzeugung von Quadrupolfeldern beaufschlagt werden. Im Gegensatz zu der in Figur 1 beschriebenen Anordnung ist der Teilchenstrom gegen die optische Achse durch die Zylinderlinsenanordnung hindurch leicht geneigt. In bekannter Weise trifft der Teilchenstrom dann auf das als Wafer bezeichnete Objekt (9) auf. Im Ergebnis erhält man ein beschreibbares Bildfeld, das bei N Anordnungen ein Bildfeld ergibt, daß das N-fache des Scanbereiches einer einzigen Linsenanordnung entspricht. Eine weitere Vergrößerung des Bildfeldes in Richtung des Spaltes der Zylinderlinse ist das Resultat.

## Patentansprüche

1. Elektronenoptische Linsenanordnung mit verschiebbarer Achse, insbesondere für die Elektronenlithographie, mit einer Zylinderlinse (6), die einen eine Mittelebene definierenden Spalt aufweist, dessen Längsachse senkrecht zur optischen Achse (3) ausgerichtet ist und mit Elektroden bzw. Polschuhen, mit denen ein Quadrupolfeld erzeugbar ist, welches die Zylinderlinse (6) überlagert und dessen Symmetrieebene in der Mittelebene des Spaltes der Zylinderlinse (6) verläuft, wobei die fokussierende Ebene des Quadrupols in Richtung des Spaltes ausgerichtet ist und wobei die fokussierende Brechkraft der Zylinderlinse doppelt so groß wie die des Quadrupols einstellbar ist,
**dadurch gekennzeichnet, dass**
die elektronenoptische Linsenanordnung zusätlich ein Ablenksystem (4, 5) zum Ablenken der Elektronen enthält, wobei
- das Ablenksystem (4, 5) im Gebrauch die Elektronen in der Mittel-ebene des Spaltes der Zylinderlinse (6) ausrichtet und bezogen auf die Elektronenstromrichtung der Zylinderlinse (6) vorgeschaltet ist und
- in Richtung des Spaltes der Zylinderlinse (6) mehrere, das Quadrupolfeld erzeugende Elektroden bzw. Polschuhe vorhanden sind, und weiter
- Steuerungsmittel vorhanden sind, durch die die Quadrupolfelder erzeugenden Elektroden bzw. Polschuhe individuell und vorzugsweise sukzessive erregbar sind und
- das Quadrupolfeld entsprechend der Ablenkung des Elektronenstrahles derart verschiebbar ist, dass der Elektronenstrahl im Bereich des Quadrupolfeldes zum Auftreffen bringbar ist.

2. Linsenanordnung nach Anspruch 1, **dadurch gekennzeichnet, dass** das Zylinder- (6) und/oder Quadrupolfeld elektrisch sind.

3. Linsenanordnung nach Anspruch 1 oder 2, **dadurch gekennzeichnet, dass** die Elektroden eine in dem Spalt der Zylinderlinse (6) angeordnete Mittelelektrode (7) bilden, die in einzelne elektrisch gegeneinander isolierte Elektrodenbereiche unterteilt ist, die individuell ansteuerbar sind.

4. Linsenanordnung bestehend aus mehreren Linsenanordnungen nach einem der vorhergehenden Ansprüche, **dadurch gekennzeichnet, dass** die Linsenanordnungen in Richtung des Spaltes der Zylinderlinsen (6) nebeneinander und aneinander anschließend angeordnet sind.

5. Linsenanordnung bestehend aus mehreren Linsenanordnungen nach einem der vorhergehenden Ansprüche, **dadurch gekennzeichnet, dass** die Linsenanordnungen senkrecht zur Richtung des Spaltes der Zylinderlinsen übereinander angeordnet sind.

6. Linsenanordnung nach einem der vorhergehenden Ansprüche, **dadurch gekennzeichnet, dass** das Ablenksystem aus zwei in Richtung des Teilchenstrahls hintereinander angeordneten und in gegensätzliche Richtungen ablenkenden Elementen besteht, durch die eine achsparallele Strahlversetzung erzeugt wird.

7. Linsenanordnung nach einem der vorhergehenden Ansprüche, **dadurch gekennzeichnet dass** das Ablenksystem (4, 5) aus einem statischen magnetischen (5) und einem zweiten, in Richtung des Strahleneinganges vorgeschalteten zeitlich veränderlichen Magnetfeld (4) aufgebaut ist.

8. Linsenanordnung nach Anspruch 7, **dadurch gekennzeichnet, dass** die Formung des Polschuhs des statischen Magnetfeldes (5) derart gewählt ist, dass unabhängig von der Ablenkung der austretende Elektronenstrom parallel zum einfallenden Elektronenstrom verläuft.

## Claims

1. Electron-optical lens arrangement with displaceable axis, in particular for electron lithography, comprising a cylindrical lens (6), which has a gap that defines a central plane and the longitudinal axis of which is oriented perpendicular to the optical axis (3), and comprising electrodes or pole shoes, by means of which a quadrupole field can be generated, which is superimposed on the cylindrical lens (6) and whose plane of symmetry extends in the central plane of the gap of the cylindrical lens (6), the focusing plane of the quadrupole being oriented in the direction of the gap and wherein the focusing refractive power of the cylindrical lens is adjusted to be twice as large as that of the quadrupole,
**characterised in that** the electron-optical lens arrangement additionally contains a deflection system (4, 5) for deflecting the electrons, wherein
- the deflection system (4,5), in use, orients electrons in the central plane of the gap of the cylindrical lens (6), and is upstream with respect to the electron beam direction of the cylindrical lens (6), and
- in the direction of the gap of the cylindrical lens (6) a plurality of electrodes and/or pole shoes generating the quadrupole field, and further
- control means are present, by means of which the electrodes and/or pole shoes generating the quadrupole fields can be individually and preferably successively excited,
- and the quadrupole field can be moved corresponding to the deflection of the electron beam such that the electron beam can be caused to impinge in the vicinity of the quadrupole field.

2. Lens arrangement according to claim 1, **characterised in that** the cylindrical (6) and/or quadrupole fields are electrical.

3. Lens arrangement according to claim 1 or 2, **characterised in that** the electrodes form a central electrode (7), which is arranged in the gap of the cylindrical lens (6) and is subdivided into individual electrode zones that are electrically insulated with respect to one another and can be individually actuated.

4. Lens arrangement consisting of a plurality of lens arrangements according to one of the preceding claims, **characterised in that** the lens arrangements are arranged side by side and contiguous with one another in the direction of the gap of the cylindrical lenses (6).

5. Lens arrangement consisting of a plurality of lens arrangements according to one of the preceding claims, **characterised in that** the lens arrangements are arranged one above the other perpendicular to the direction of the gap of the cylindrical lenses.

6. Lens arrangement according to one of the preceding claims, **characterised in that** the deflection system comprises two elements that are arranged one behind the other in the direction of the particle beam and deflect in opposite directions, by means of which an axially parallel beam-shift is generated.

7. Lens arrangement according to one of the preceding claims, **characterised in that** the deflection system (4, 5) consists of a static magnetic field (5) and a second magnetic field (4) that is disposed upstream in the direction of the beam entry and is time-variable.

8. Lens arrangement according to claim 7, **characterised in that** the shape of the pole shoe of the static magnetic field (5) is chosen such that, irrespective of the deflection, the emerging electron beam travels parallel to the incident electron beam.

## Revendications

1. Disposition optique électronique de lentilles à axe déplaçable, notamment pour la lithographie électronique, avec une lentille cylindrique (6) qui présente une fente définissant un niveau médian dont l'axe longitudinal est orienté à la verticale par rapport à l'axe optique (3), et qui dispose d'électrodes ou de masses polaires capables de générer un champ quadripolaire qui se superpose à la lentille cylindrique (6) et dont le niveau de symétrie court dans le niveau médian de la fente de la lentille cylindrique (6), sachant que le niveau focussant du quadripôle est orienté en direction de la fente, et sachant que la vergence focussante de la lentille cylindrique peut être réglée à une grandeur double de celle du quadripôle,
**caractérisée par le fait que** la disposition optique électronique de lentilles contient en outre un système de déviation (4, 5) destiné à faire dévier les électrons, sachant que
■ le dispositif de déviation (4, 5) utilisé dirige les électrons dans le niveau médian de la fente cylindrique (6) et est branché en amont par rapport à la direction du flux d'électrons de la lentille cylindrique (6) et
■ qu'il y a plusieurs électrodes ou masses polaires générant le champ quadripolaire en direction de la fente de la lentille cylindrique (6), et
■ qu'il existe en outre des moyens de commande capables d'induire, individuellement et de préférence successivement, les électrodes ou les masses polaires générant les champs quadripolaires et
■ que le champ quadripolaire peut être déplacé conformément à la déviation du rayon électronique de telle façon que l'on peut amener le rayon d'électrons à impacter dans la zone du champ quadripolaire.

2. Disposition de lentilles selon la revendication 1, **caractérisée par le fait que** le champ cylindrique (6) et/ou quadripolaire est électrique.

3. Disposition de lentilles selon la revendication 1 ou 2, **caractérisée par le fait que** les électrodes forment une électrode médiane (7) disposée dans la fente de la lentille cylindrique (6), qui est subdivisée en zones d'électrodes isolées les unes par rapport aux autres pouvant être commandées individuellement.

4. Disposition de lentilles consistant en plusieurs dispositions de lentilles selon une des revendications précédentes, **caractérisée par le fait que** les dispositions de lentilles sont disposées en direction de la fente des lentilles cylindriques (6), les unes à côté des autres et les unes derrières les autres.

5. Disposition de lentilles consistant en plusieurs dispositions de lentilles selon une des revendications précédentes, **caractérisée par le fait que** les dispositions de lentilles sont disposées les unes au dessus des autres, verticalement par rapport à la direction de la fente des lentilles cylindrique.

6. Disposition de lentilles selon une des revendications précédentes,
**caractérisée par le fait que** le système de déviation consiste en deux éléments disposés l'un derrière l'autre en direction du rayon de particules et déviant dans des directions opposées, et qui génèrent un décalage du rayon d'axe parallèle.

7. Disposition de lentilles selon une des revendications précédentes,
**caractérisée par le fait que** le système de déviation (4, 5) est constitué d'un champ magnétique statique (5) et d'un deuxième champ magnétique (4) branché en amont en direction de l'entrée du rayon, modifiable dans le temps.

8. Disposition de lentilles selon la revendication 7, **caractérisée par le fait que** la forme de la masse polaire du champ magnétique statique (5) est choisie de manière à ce que le rayon d'électrons sortant coure parallèlement au rayon d'électrons entrant, indépendamment de la déviation.
